# EUROPÄISCHE PATENTSCHRIFT

(11) **EP 3 508 041 B1**
(45) Veröffentlichungstag und Bekanntmachung des Hinweises auf die Patenterteilung: **30.09.2020**
(21) Anmeldenummer: 17761480.7
(22) Anmeldetag: 31.08.2017
(51) Int. Cl.: H05K 3/32, H05K 1/14, B60L 50/40, B60L 50/64, H01R 12/91, H01G 2/04, H01G 11/46

(54) **SCHALTUNGSANORDNUNG, INSBESONDERE FÜR EIN ELEKTRISCH ANGETRIEBENES KRAFTFAHRZEUG**
CIRCUIT ARRANGEMENT, IN PARTICULAR FOR AN ELECTRICALLY MOTORISED VEHICLE
ARRANGMENT DE CIRCUIT, EN PARTICULIER POUR VÉHICULE ACTIONNÉ ÉLECTRIQUEMENT

(30) Priorität: 01.09.2016 DE 102016216507
(43) Veröffentlichungstag der Anmeldung: 10.07.2019
(73) Patentinhaber: Valeo Siemens eAutomotive Germany GmbH, 91056 Erlangen (DE)
(72) Erfinder: EICHNER, Markus, 90403 Nürnberg (DE); HEUMANN, Christoph, 90427 Nürnberg (DE); HOYLER, Christoph, 91241 Kirchensittenbach (DE); MÜLLER, Alex, 90425 Nürnberg (DE)
(74) Vertreter: Dr. Gassner & Partner mbB
(86) Internationale Anmeldenummer: PCT/EP2017/071906
(87) Internationale Veröffentlichungsnummer: WO 2018/041970

(56) Entgegenhaltungen:
- EP-A2- 0 501 171
- EP-A2- 2 112 717
- WO-A2-2010/002156
- DE-A1-102012 201 754
- US-A- 6 024 589
- US-A1- 2011 235 348

## Beschreibung

Die Erfindung betrifft eine Schaltungsanordnung, insbesondere für ein elektrisch angetriebenes Kraftfahrzeug.

Bei Schaltungsanordnungen für elektrisch angetriebene Kraftfahrzeuge werden typischer Weise starre Stromschienen zum Leiten eines elektrischen Stroms von einem Versorger zu einem Abnehmer eingesetzt. Die elektrische Kontaktierung des Abnehmers erfolgt bei bekannten, beispielsweise als Umrichter ausgebildeten Abnehmern über Löt- oder Schweißverbindungen oder über Schraubkontakte.

Die Verwendung derartig starrer Verbindungstechniken ist für den Fall, dass mehrere elektrische Bauteile bzw. Abnehmer elektrisch kontaktiert werden müssen, problematisch. Um die bauteilabhängige Toleranzlage einzuhalten, wird daher für jeden Abnehmer eine eigene Stromschiene bzw. ein eigenes Stromschienenpaar vorgesehen. Bei einer großen Anzahl von anzuschließenden Abnehmern geht dieser Ansatz mit einer erheblichen Bauteilvielfalt einher, die erhöhte Herstellungskosten bedingt. Eine Schaltungsanordnung, gemäß dem Oberbegriff von Anspruch 1, ist aus dem Dokument US-A1-2011/235348 bekannt.

Es ist Aufgabe der Erfindung eine Schaltungsanordnung anzugeben, welches den Anforderungen hinsichtlich der einzuhaltenden Bauteiltoleranzen in eine für die Serienproduktion kostengünstig zu realisierende Art und Weise genügt.

Diese Aufgabe wird gelöst durch eine Schaltungsanordnung mit den weiteren Merkmalen des Patentanspruchs 1.

Vorteilhafte Weiterbildungen der Erfindung sind Gegenstand der Unteransprüche.

Eine Schaltungsanordnung, insbesondere für ein elektrisch angetriebenes Kraftfahrzeug, weist zumindest eine an einem Versorger elektrisch angeschlossene Stromschiene auf, die mit einem ersten Abnehmer an einer ersten Übergabestelle und mit einem zweiten Abnehmer an einer zweiten Übergabestellen elektrisch verbunden ist. Die erste und die zweite Übergabestelle sind als flexible Kontaktstellen ausgebildet.

Es wird somit eine Mehrfachkontaktierung der Stromschiene derart vorgeschlagen, dass ein elektrischer Strom an mehrere Abnehmer zuführbar ist. Im Ergebnis sind somit weniger Bauteile für die elektrische Zuleitung notwendig, so dass die Stückkosten reduziert werden können. Die erforderliche Toleranzlage wird im Gegenzug dadurch sichergestellt, dass keine starren Verbindungstypen, insbesondere keine Löt-, Schweiß- oder Schraubverbindungen zur elektrisch leitenden Kontaktierung zum Einsatz kommen. Die Kontaktstelle ist vielmehr flexibel ausgebildet, also zumindest zum Teil von derart elastischen oder biegsamen Elementen gebildet, dass selbst eine geringfügige Bewegung von Stromschiene und Abnehmer an der ersten und/oder zweiten Übergabestelle beispielsweise im Rahmen von betriebsbedingten Vibrationen und/oder Erschütterungen kompensiert werden kann. Dies ermöglicht zum einen den Ausgleich von bauartbedingten, insbesondere unterschiedlichen Toleranzen an der ersten und/oder zweiten Übergabestelle bei gleichzeitiger Verwendung von an sich starr ausgebildeten Stromschienen. Zum anderen eignet sich die derartig erschütterungs- bzw. stoßfest ausgebildete Schaltungsanordnung im besonderen Maße für den Einsatz in elektrisch angetriebenen Kraftfahrzeugen.

Mit elektrisch angetriebenen Kraftfahrzeugen sind solche gemeint, die zumindest einen zum Vortrieb des Kraftfahrzeugs ausgebildeten elektrischen Antrieb aufweisen. Diese Definition schließt insbesondere sogenannte Hybridfahrzeuge ein, bei denen typischer Weise zusätzlich zum elektrischen Antrieb ein Verbrennungsmotor vorgesehen ist.

In Weiterbildung der Erfindung ist vorgesehen, mehrere Abnehmer, also mehr als zwei Abnehmer, über eine Stromschiene mit einer der Anzahl der Abnehmer entsprechenden Anzahl von Übergabestellen elektrisch anzubinden. Jede der Übergabestellen ist dabei als flexible Kontaktstelle ausgebildet.

Die elektrisch leitende Verbindung ist an den flexiblen Kontaktstellen vorzugsweise mittels einer kraft- und/oder formschlüssigen Verbindung gebildet.

Die flexiblen Kontaktstellen sind in möglichen Ausführungsbeispielen als Einpresskontakte und/oder Federkontakte ausgebildet. Federkontakte können insbesondere Federkontaktelemente umfassen, die in Richtung einer Kontaktfläche federnd vorgespannt sind, die auf einer Leiterplatte des ersten und/oder zweiten Abnehmers oder auf der Stromschiene angeordnet ist. Die elektrische Kontaktierung erfolgt somit mittels eines Kraftschlusses.

Bekannte Einpressverbindungen weisen im Allgemeinen stiftförmige Kontaktteile mit Verformzonen auf. Das Kontaktteil wird zur Kontaktierung in ein weiteres, komplementär ausgebildetes Kontaktteil derart eingepresst, dass im Bereich der Verformzone eine kraft- und formschlüssige, elektrisch leitende Verbindung gebildet wird. Die hierzu aufzuwendende Einpresskraft beträgt typischer Weise mehrere 100 N.

In einem möglichen Ausführungsbeispiel der Erfindung ist zumindest eine der flexiblen Kontaktstellen als Einpresskontakt ausgebildet, der gabelartige Kontaktelemente aufweist, die endseitig von der Stromschiene hervorstehen und in eine starre Kontaktbuchse des ersten und/oder zweiten Abnehmers kraftschlüssig eingepresst sind. Die gabelartigen Kontaktelemente sind flexibel und können somit Bauteiltoleranzen bzw. Erschütterungen oder Vibrationen ausgleichen.

Besonders bevorzugt sind die gabelartigen Kontaktelemente derart flexibel ausgebildet, dass der Kraftschluss zwischen den gabelartigen Kontaktelementen und der elektrisch leitende Kontaktbuchse von einer Einpresskraft erzeugbar ist, die weniger als 100 N, insbesondere etwa 30 N bis 50 N beträgt. Mit anderen Worten kann die elektrische Kontaktierung des ersten und/oder zweiten Abnehmers mit einem gegenüber den gängigen Einpresstechniken deutlich verminderten Kraftaufwand erfolgen.

Bei Federkontakten ist das die elektrisch leitende Verbindung bereitstellende Kontaktelement beispielsweise durch eine separate Feder vorgespannt. In anderen Ausführungsbeispielen ist das Kontaktelement selbst als Federkontaktelement ausgebildet und verfügt somit zumindest über einen federnden Abschnitt.

Der erste und/oder zweite Abnehmer umfasst vorzugsweise einen Schaltungsträger, insbesondere eine Leiterplatte mit darauf angeordneten und miteinander verschalteten elektronischen Komponenten. In einem möglichen Ausführungsbeispiel implementiert der erste und/oder zweite Abnehmer eine Steuerungslogik für eine Leistungselektronik des Kraftfahrzeugs.

Der Versorger im Sinne der vorliegenden Spezifikation ist ein Element oder Bauteil, welches zumindest zeitweise als Energiequelle fungieren kann. Diese Definition umfasst also herkömmliche Strom- bzw. Spannungsquellen, wie insbesondere Batterien, aber auch Energiepuffer, die beispielsweise von einem Kondensator oder mehreren, insbesondere parallel verschalteten Kondensatoren bereitgestellt werden können.

In einem möglichen Ausführungsbeispiel ist die Schaltungsanordnung Teil einer Steuerungselektronik für einen Stromumrichter, beispielsweise für einen Frequenzumrichter eines Elektromotors. Derartige Schaltungsanordnungen werden beispielsweise von einem Gleichspannungs-Zwischenkreis gespeist, an dem auch Leistungshalbleitermodule für den Elektromotor angeschlossen sind. Der Elektromotor ist bevorzugt als Antriebsaggregat eines elektrisch betriebenen Kraftfahrzeugs ausgebildet. In diesem Fall wird der Gleichspannungs-Zwischenkreis typischer Weise direkt von einer Batterie gespeist. Der Gleichstrom-Zwischenkreis weist einen Kondensator oder mehrere verschaltete Kondensatoren auf, die üblicher Weise als Zwischenkreiskondensatoren bezeichnet werden, und dient somit als Energiepuffer für einen nachgeschalteten Stromrichter, insbesondere für einen nachgeschalteten Wechselrichter. Der erste und/oder zweite Abnehmer kann beispielsweise auch als Gleichspannungswandler ausgebildet sein, der von dem Zwischenkreiskondensator gespeist wird und seine Leistungsaufnahme von insbesondere mehreren Kilowatt, von diesem bezieht.

Für eine weitere Beschreibung der Erfindung wird auf das in den Zeichnungsfiguren gezeigte Ausführungsbeispiel verwiesen. Es zeigen in einer schematischen Darstellung:
- FIG 1: eine Schaltungsanordnung mit einer mehrfach kontaktierten Stromschiene in einer schematischen Seitenansicht, und
- FIG 2: Details der elektrischen Kontaktierung der Stromschiene an einer ersten und einer zweiten Übergabestelle in einer schematischen Schnittdarstellung.

Einander entsprechende Teile sind in allen Figuren mit den gleichen Bezugszeichen versehen.

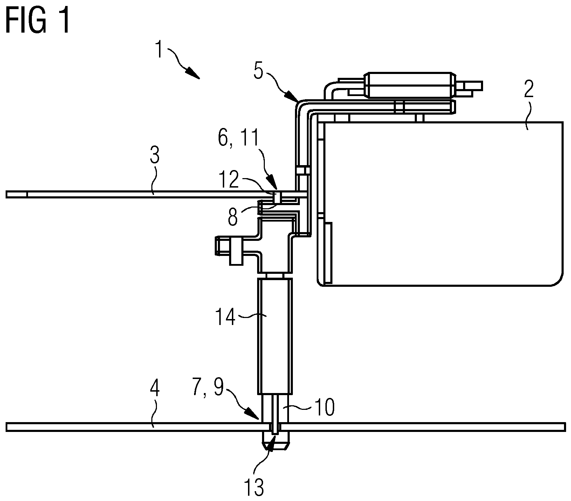

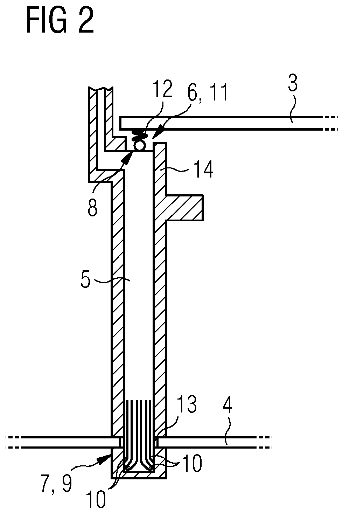

FIG 1 zeigt den schematischen Aufbau einer Schaltungsanordnung 1, welche beispielsweise die Funktion eines Steuerungsmoduls für einen Stromrichters mit integriertem Gleichstromwandler ausführt. Ein Versorger 2 umfasst einen Batterie gespeisten Gleichspannungs-Zwischenstromkreis mit einem Zwischenkreiskondensator, der einen Energiespeicher für mehrere daran angekoppelte elektrische Netze bereitstellt. Der Versorger 2 ist mit ersten und zweiten Abnehmern 3, 4 über zwei starre Stromschienen 5 verbunden, die parallel zueinander in einem Gehäuse 14 geführt sind. Die ersten und zweiten Abnehmer 3, 4 umfassen in nicht näher dargestellter Art und Weise mehrere auf Leiterplatten angeordnete elektronische Komponenten, denen über die Stromschiene 5 ein elektrischer Strom zuführbar ist. Der erste Abnehmer 3 ist hier eine elektronische Steuerung für einen Wechselrichter eines im Antriebsstrang eines Kraftfahrzeugs vorgesehenen Elektromotors. Der zweite Abnehmer 4 ist ein Gleichspannungswandler. Die elektrisch leitende Kontaktierung der Stromschienen 5 mit dem ersten Abnehmer erfolgt an ersten Übergabestellen 6. Entsprechend erfolgt die elektrische leitende Kontaktierung des zweiten Abnehmers 4 an zweiten Übergabestellen 7. Jede Stromschiene weist daher zwei Übergabestellen 6, 7 zur Kontaktierung des ersten und zweiten Abnehmers 3, 4 auf. Details der elektrischen Kontaktierung der Stromschiene 5 im Bereich der ersten und zweiten Übergabestellen 6, 7 sind in FIG 2 dargestellt.

Sowohl die erste als auch die zweite Übergabestelle 6, 7 sind als flexible Kontaktstellen ausgeführt. Die flexible Kontaktstelle ist an der ersten Übergabestelle 6 durch einen Federkontakt 11 realisiert, wobei ein Stirnkontakt dadurch gebildet ist, dass ein Federkontaktelement 12 durch eine Aussparung im Gehäuse 14 hindurch greift und eine Kontaktfläche 8 auf der Stromschiene 5 kontaktiert. Das Federkontaktelement 12 ist auf der Leiterplatte des ersten Abnehmers 3 vorgesehen und in Richtung der Kontaktfläche 8 federnd vorgespannt. Die elektrisch leitfähige Verbindung wird in diesem Fall durch einen Kraftschluss zwischen dem Federkontaktelement 12 und der Kontaktfläche 8 sichergestellt.

Der zweite Abnehmer 4 ist über Einpresskontakte 9 mit den Stromschienen 5 elektrisch leitend verbunden. Wie in FIG 2 dargestellt, ist in der Leiterplatte des zweiten Abnehmers 4 eine hülsenförmige Kontaktbuchse 13 mit einer elektrisch leitenden inneren Oberfläche eingebracht, die von gabelartigen Kontaktelementen 10 kraft- und formschlüssig kontaktiert werden. Die gabelartigen Kontaktelemente 10 sind derart flexibel und federnd ausgebildet, dass zum einen betriebsbedingte Vibrationen und Bauteiltoleranzen ausgeglichen werden können. Zum anderen ist die zum Einpressen der Kontaktelemente 10 in die Kontaktbuchse 13 notwendige Kraft gegenüber herkömmlichen Einpresskontakten, bei denen beim Einpressvorgang eine zumindest abschnittsweise plastische Verformung des Kontaktteils erfolgt, deutlich vermindert.

Obwohl die Erfindung im Detail mit Bezug auf das bevorzugte Ausführungsbeispiel näher illustriert und beschrieben wurde, so ist die Erfindung nicht hierdurch eingeschränkt. Andere Variationen und Kombinationen können vom Fachmann hieraus abgeleitet werden, ohne vom wesentlichen Gedanken der Erfindung zu abzuweichen.

## Patentansprüche

1. Schaltungsanordnung (1), insbesondere für ein elektrisch angetriebenes Kraftfahrzeug, mit zumindest einer an einem Versorger (2) elektrisch angeschlossenen Stromschiene (5), die mit einem ersten Abnehmer (3) an einer ersten Übergabestelle (6) elektrisch verbunden ist, wobei die erste Übergabestelle (6) als flexible Kontaktstelle ausgebildet ist, **dadurch gekennzeichnet,**
**dass** die Stromschiene (5) mit einem zweiten Abnehmer an einer zweiten Übergabestelle (7), die als flexible Kontaktstelle ausgebildet ist, elektrisch verbunden ist, wobei zumindest eine der flexiblen Kontaktstellen als Einpresskontakt (11) ausgebildet ist, wobei jeder Einpresskontakt (11) gabelartige Kontaktelemente aufweist, die endseitig von der Stromschiene (5) hervorstehen und in eine starre Kontaktbuchse des ersten und/oder zweiten Abnehmers kraftschlüssig eingepresst sind.

2. Schaltungsanordnung (1) nach Anspruch 1,
wobei die elektrisch leitende Verbindung an den flexiblen Kontaktstellen mittels einer kraft- und/oder formschlüssigen Verbindung gebildet ist.

3. Schaltungsanordnung nach Anspruch 1 oder 2,
wobei die gabelartigen Kontaktelemente derart flexibel ausgebildet sind, dass der Kraftschluss zwischen den gabelartigen Kontaktelementen und der Kontaktbuchse von einer Einpresskraft erzeugbar ist, die weniger als 100 N, insbesondere etwa 30 N bis 50 N beträgt.

4. Schaltungsanordnung nach einem der Ansprüche 1 bis 3, wobei zumindest einer der flexiblen Kontaktstellen als Federkontakt (9) ausgebildet ist.

5. Schaltungsanordnung (1) nach einem der vorhergehenden Ansprüche,
wobei der erste und/oder zweite Abnehmer (3, 4) einen Schaltungsträger, insbesondere eine Leiterplatte mit darauf angeordneten und miteinander verschalteten elektronischen Komponenten umfasst.

6. Schaltungsanordnung (1) nach einem der vorhergehenden Ansprüche,
wobei der Versorger (4) einen Kondensator, insbesondere einen Zwischenkreiskondensator eines Gleichspannungs-Zwischenkreises umfasst.

## Claims

1. Circuit arrangement (1), in particular for an electrically driven motor vehicle, having at least one busbar (5) which is electrically connected to a supplier (2) and is electrically connected to a first collector (3) at a first transfer point (6), the first transfer point (6) being designed as a flexible contact point,
**characterized in that**
the busbar (5) is electrically connected to a second collector at a second transfer point (7) which is designed as a flexible contact point, wherein at least one of the flexible contact points being designed as a press-fit contact (11), each press-fit contact (11) having fork-like contact elements which project from the busbar (5) at the ends and are pressed into a rigid contact socket of the first and/or second pickup in a force-fitting manner.

2. Circuit arrangement (1) according to claim 1,
wherein the electrically conductive connection is formed at the flexible contact points by means of a force-locking and/or form-locking connection.

3. Circuit arrangement according to claim 1 or 2,
wherein the fork-like contact elements are designed to be so flexible that the force closure between the fork-like contact elements and the contact socket can be generated by a press-in force which is less than 100 N, in particular about 30 N to 50 N.

4. Circuit arrangement according to any of claims 1 to 3,
wherein at least one of the flexible contact points is designed as a spring contact (9).

5. Circuit arrangement (1) according to any of the preceding claims,
wherein the first and/or second collector (3, 4) comprises a circuit carrier, in particular a printed circuit board with electrical components arranged thereon and interconnected with one another.

6. Circuit arrangement (1) according to any of the preceding claims, wherein the power supply (4) comprises a capacitor, in particular an intermediate circuit capacitor of a DC intermediate circuit.

## Revendications

1. Circuit (1), en particulier pour un véhicule automobile à propulsion électrique, comportant au moins une barre omnibus (5) raccordée électriquement à un élément d'alimentation (2), la dite barre omnibus étant reliée électriquement à un premier consommateur (3) au niveau d'un premier point d'échange (6), en ce que le premier point d'échange (6) se présente sous forme de point de contact flexible, **caractérisé en ce que** la barre omnibus (5) est reliée électriquement à un deuxième consommateur au niveau d'un deuxième point d'échange (7) qui se présente sous forme de point de contact flexible, **en ce qu'**au moins l'un des points de contact flexibles se présente sous forme de contact d'insertion (11), **en ce que** chaque contact d'insertion (11) présente des éléments de contact en forme de lyre qui font saillie côté extrémité de la barre omnibus (5) et qui sont insérés par adhérence dans un contact femelle rigide du premier et/ou du deuxième consommateur.

2. Circuit (1) selon la revendication 1, en ce que la connexion électriquement conductrice au niveau des points de contact flexibles est réalisée au moyen d'une connexion par adhérence ou par solidarisation.

3. Circuit selon la revendication 1 ou 2, en ce que les éléments de contact en forme de lyre sont de conception si flexible que l'adhérence entre les éléments de contact en forme de lyre et le contact femelle peut être générée par une force d'insertion qui est inférieure à 100 N, en particulier comprise approximativement entre 30 N et 50 N.

4. Circuit selon l'une des revendications 1 à 3, en ce qu'au moins l'un des points de contact flexibles est réalisé sous forme de contact à ressort (9).

5. Circuit (1) selon l'une des revendications précédentes, en ce que le premier et/ou le deuxième consommateur (3, 4) comporte un support de circuit, en particulier une carte imprimée sur laquelle des composants électroniques sont disposés et raccordés entre eux.

6. Circuit (1) selon l'une des revendications précédentes, en ce que le consommateur (4) comprend un condensateur, en particulier un condensateur de circuit intermédiaire d'un circuit intermédiaire de tension continue.
